# EUROPÄISCHE PATENTSCHRIFT

(11) **EP 0 436 930 B1**
(45) Veröffentlichungstag und Bekanntmachung des Hinweises auf die Patenterteilung: **01.10.1997**
(21) Anmeldenummer: 90125515.8
(22) Anmeldetag: 27.12.1990
(51) Int. Cl.: G03F 9/00

(54) **Verfahren zum Ausrichten von zwei aufeinander einzujustierenden Objekten anhand von Justiermarken**
Method for aligning two objects in superposition using alignment marks
Procédé pour aligner deux objets destinés à un alignement en superposition en utilisant des marques d'alignement

(30) Priorität: 12.01.1990 DE 4000785
(43) Veröffentlichungstag der Anmeldung: 17.07.1991
(73) Patentinhaber: Karl Süss KG Präzisionsgeräte für Wissenschaft und Industrie - GmbH & Co., D-85748 Garching (DE)
(72) Erfinder: Kaiser, Paul, W- 8000 München 70 (DE)
(74) Vertreter: VOSSIUS & PARTNER

(56) Entgegenhaltungen:
- EP-A- 0 140 022
- DE-A- 4 031 637
- US-A- 3 821 545
- US-A- 3 928 094
- US-A- 4 815 854
- SOVIET INVENTIONS ILLUSTRATED Section EI, Week 8426, 8. August 1984 Derwent Publications Ltd., London, GB; Class U, Page 2, AN 84-163187/26 & SU-A-1 046 734 (GREVTSEV N V) 7. Oktober 1983

## Beschreibung

Die Erfindung betrifft ein Verfahren zur Ausrichtung von zwei aufeinander einzujustierenden Objekten der im Oberbegriff des Anspruchs 1 angegebenen Art. Die Justiermarken bestehen aus geraden Linien, deren Position unter anderem durch zeilenweises opto-elektronisches Abtasten von Auswerteflächen und Integration der gewonnnenen Helligkeitswerte bestimmt wird. Solche Justiermarken kommen insbesondere in der Halbleitertechnologie zum Einsatz und werden dort zur gegenseitigen Ausrichtung von Wafer und Maske bei der Photolithographie verwandt.

Justiermarken, die aus geraden Linien bestehen, die bei der Positionierung zeilenweise optoelektronisch abgetastet und deren Helligkeitswerte anschließend integriert werden, sind aus der DE-28 22 269 bekannt. Sie bestehen aus einem Muster von zueinander orthogonal angeordneten, sich kreuzenden geraden Linien auf beiden einzujustierenden Objekten (Wafer, Maske). Die Ausrichtung der Objekte erfolgt in der Weise, daß die Justiermarken-Linien des Wafers parallel zu denen der Maske verlaufen. Obwohl die Justiermarken in unterschiedlichen optischen Ebenen liegen, ist es unvermeidlich, daß die Justiermarke des Wafers, wenn auch verschwommen, durch die der Maske bzw. auch die Linien der Maske bei der Auswertung der Justiermarke des Wafers noch sichtbar sind. Beim zeilenweisen Abtasten in jeweils einer Objektebene werden diese unerwünschten Einflüsse des anderen Objekts mit erfaßt und führen zu Ungenauigkeiten bei der Bestimmung der Linienposition. Ein weiterer Nachteil der Justiermarken im Stand der Technik besteht darin, daß die Integrationslänge bei schwachem Kontrast zu gering ist und die gekreuzten Linien unerwünschte Abschattungen des Wafers durch die Maske erzeugen, die durch Aperturreduzierung die Auflösung des Waferbildes verschlechtern.

Aus der EP-A-140 022 ist ein optisches Selbstausrichtungssystem bekannt. Das System weist eine Laserquelle und ein Substrat mit einem ersten Beugungsgitter und ein Substrat mit einem zweiten Beugungsgitter auf, welches innerhalb der Fresnelzone des ersten Beugungsgitters angeordnet ist. Ein Detektor detektiert Fraunhofer-Beugungsstrahlen nullter Ordnung von dem zweiten Beugungsgitter. Die beiden Substrate werden miteinander ausgerichtet durch Feststellen der Verlagerung des Moire-Signals. Die Linien der Beugungsgitter auf beiden Substraten sind parallel zueinander angeordnet.

Die US-A-3 821 545 offenbart die Maskenausrichtung bei der Herstellung von Halbleiterschaltkreisen. Die Maske besteht aus mehreren Fenstern, die oberhalb eines reflektierenden Musters auf einem Substrat angeordnet sind. Die Maske wird auf dem Substrat ausgerichtet, indem der Betrag des am Substrat reflektierten Lichts, der durch die Fenster der Maske hindurchgeht, gemessen wird.

Die US-A-4 815 854 betrifft ein Verfahren zur Ausrichtung einer Maske und eines Substrats. Dabei wird eine Fresnel-Zonenplattenlinse auf der Maske angeordnet und erste und zweite Reflexionsgitter sind auf dem Substrat vorhanden. Die Reflexionsgitter weisen konkave und konvexe Stellen mit gleichem Abstand auf, wobei die Abstände bei dem ersten und dem zweiten Reflexionsgitter unterschiedlich sind. Die Maske wird mit monochromatischer Strahlung bestrahlt, und die reflektierte Strahlung an den ersten und zweiten Reflexionsgittern des Substrats wird gemessen, wobei die Maske entsprechend einem Differenzwert der Reflexionen vom ersten und zweiten Reflexionsgitter ausgerichtet wird.

Aus der US-A-3 928 094 ist ein Ausrichtungsverfahren für eine Maske und einen Wafer bekannt. Der Wafer weist beabstandete Stufen einer bestimmten Länge auf, die ein Muster von parallelem Linien ausbilden. Die Maske weist symmetrische Öffnungen auf, die orthogonal zu den Stufen angeordnet sind. Die Stufen des Wafers werden durch die Öffnung der Maske hindurch beleuchtet und gleichzeitig wird eine erste Streulichtstrahlung von einem Ende der Stufen und eine zweite Streulichtstrahlung von dem anderen Ende der Stufen gemessen. Der Wafer wird beim Ausrichten relativ zur Maske bewegt, bis das erste Streulicht in einem bestimmten Verhältnis zum zweiten Streulicht steht.

Der Erfindung liegt die Aufgabe zugrunde, ein Verfahren zur Ausrichtung von zwei aufeinander einzujustierenden Objekten zur Verfügung zu stellen, bei dem Fehler infolge optischer Einflüsse des anderen Objekts bei der Auswertung vermieden werden und eine hohe Auswertegeschwindigkeit erreicht wird.

Die Aufgabe wird mit den Merkmalen des Anspruchs 1 gelöst.

Die Vorteile des erfindungsgemäßen Justierverfahrens gegenüber dem Stand der Technik bestehen in einer höheren Positioniergenauigkeit, einem größeren Einfangbereich bei der Grobjustierung und einer schnelleren Fokusbestimmung.

Die Erfindung wird mit Bezug auf die Zeichnung näher erläutert. Es zeigen:
- Figur 1: eine Maskenjustiermarke mit den bei horizontaler und vertikaler Zeilenabtastung (x- und y-Richtung) erfaßten Bereichen, Diagramm: Helligkeitswerte integriert in y- bzw. x-Richtung,
- Figur 2: eine Waferjustiermarke unter der Maskenjustiermarke mit den bei horizontaler und vertikaler Zeilenabtastung (x- und y-Richtung) der Maskenjustiermarke miterfaßten Bereichen, Diagramm: Helligkeitswerte mitintegriert in y- bzw. x-Richtung
- Figur 3: resultierende Helligkeitswerte der Maskenjustiermarken mit dem Untergrundsignal von der Waferjustiermarke und Waferjustiermarke

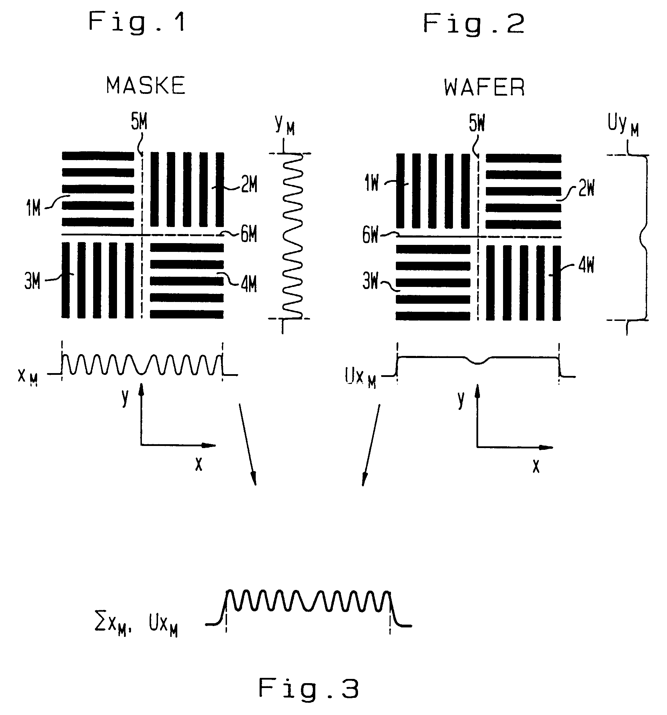

Die Figuren 1 und 2 zeigen für das erfindungsgemäße Verfahren verwendbare Justiermarken auf einer photolithographischen Maske bzw. einem Wafer. Die Auswertung erfolgt z.B. nach dem Prinzip der Mustererkennung. Mittels eines photographischen Abbildungssystems, z.B. einer CCD-Kamera, wird ein Bild der auszuwertenden Bereiche aufgenommen. Sowohl bei der Maskenals auch bei der Waferjustiermarke werden die Helligkeitswerte in Bereichen gleicher Linienrichtung zeilenweise abgetastet und in einer dazu orthogonalen Richtung integriert. Sie liefern Signale des Linienmusters. Mittels eines entsprechenden Auswerteverfahrens wird dann die Position der Linien bestimmt und zur gegenseitigen Ausrichtung von Maske und Wafer verwandt.

Für die Abtastung der Maske in der (in der Zeichnung horizontalen) x-Richtung werden die beiden Auswertebereiche 3M und 2M abgetastet; durch Integration der Helligkeitswerte in vertikaler Richtung erhält man das X_{M}-Signal (dabei werden in vorteilhafter Weise die eventuell mit abgetastetenen Hel-ligkeitswerte aus den Bereichen 1M und 4M nicht mitintegriert, d.h. die Linie 6M bildet die obere bzw. untere Integrationsgrenze für die Auswertebereiche 3M bzw. 2M). Bei dieser Zeilenabtastung der optisch transparenten Maskenjustiermarke wird die durchscheinende darunterliegende orthogonale Zeilenstruktur der Waferjustiermarke mit den Auswertebereichen 3W und 2 W in Figur 2 mit erfaßt; sie liefert jedoch nur einen konstanten Untergrund U_{xM} für die Helligkeitswerte der Maskenjustiermarke, und die Überlagerung bewirkt lediglich eine Anhebung des Signalniveaus (Summensignal Σ X_{M},U_{xM} in Figur 3). Dadurch wird die Flankenlage und Form der Signale nicht beeinflußt, und die Position der Justiermarkenlinien kann sehr genau bestimmt werden. Entsprechend erhält man für die (in der Zeichnung vertikale) y-Richtung bei Abtastung der Auswertebereiche 1M und 4M der Maske das y_{M}-Signal und dabei vom Wafer (Auswertebereiche 1W bzw. 4W) das Untergrundsignal U_{xM} und insgesamt das Summensignal Σ y_{M},U_{yM}. Die beiden Signale Σ X_{M},U_{xM} und Σ y_{M},U_{yM} können nun direkt zur Positionsbestimmung bzw. Justierung der Maske in üblicher Weise weiter ausgewertet werden. Entsprechende Positionssignale des Wafers werden mit oder ohne Maske aus den Auswertebereichen 1W und 4W (für die x-Richtung) und aus den Auswertebereichen 3W und 2W (für die y-Richtung) gewonnen. Durch Soll-Istwert-Vergleich der Positionssignale von Wafer und Maske erfolgt dann die Justierung.

Mit dem erfindungsgemäßen Justierverfahren läßt sich bei der optoelektronischen Auswertung eine hohe Linienauflösung erzielen und daher auch eine hohe Liniendichte realisieren. Dadurch erhöht sich der Informationsgehalt der Justiermarken. So stehen für eine genaue Fokusbestimmung auch bei deutlicher Dejustierung genügend Linien zur Verfügung und gestatten eine sehr gute und schnelle Fokussierung. Ferner erlaubt die hohe Liniendichte bei der Grobjustierung eine sehr eindeutige Erkennung der Justiermarken, wodurch sich ein großer Einfangbereich ergibt.

Andere erfindungsgemäße Ausführungsformen können bei den Masken- und Waferjustiermarken auch unterschiedliche Liniendichten und -breiten aufweisen, wobei eine geringe Liniendichte bei der Maskenjustiermarke bevorzugt ist, um Abschattungseffekte zu minimieren.

Die Zwischenräume zwischen den Auswertebereichen (1M bis 4M; 1E bis 4W) sollten groß genug sein, um Überlagerungseffekte der Liniensignale aus verschiedenen Auswertebereichen auszuschließen.

## Patentansprüche

1. Verfahren zum Ausrichten von zwei aufeinander einzujustierenden Objekten, von denen mindestens das obere optisch transparent ist, insbesondere eines Wafers und einer Maske in der Halbleitertechnologie, wobei Justiermarken, die parallele, sich nicht kreuzende gerade Linien mit unterschiedlicher Helligkeit aufweisen, zum Justieren übereinanderliegen, dadurch gekennzeichnet, daß
die geraden Linien von zwei direkt übereinanderliegenden Justiermarkenbereichen in der Sollposition nicht parallel zueinander angeordnet sind, und
die Justiermarken auf beiden Objekten zeilenweise optoelektronisch abgetastet und die gewonnenen Helligkeitswerte in einer dazu orthogonalen Richtung integriert werden, wobei Signale der Linienmuster erhalten werden.

2. Verfahren nach Anspruch 1, dadurch gekennzeichnet, daß die geraden Linien zweier übereinanderliegender Justiermaken im wesentlichen orthogonal zueinander angeordnet werden.

3. Verfahren nach Anspruch 1 oder 2, dadurch gekennzeichnet, daß die geraden Linien ein periodisches Gitter ausbilden.

4. Verfahren nach Anspruch 1 oder 2, dadurch gekennzeichnet, daß die geraden Linien ein Gitter mit zwei oder drei Gitterkonstanten ausbilden.

5. Verfahren nach einem der Ansprüche 1 bis 4, dadurch gekennzeichnet, daß die Liniendichte auf dem Wafer größer ist als auf der Maske.

6. Verfahren nach einem der Ansprüche 1 bis 5, dadurch gekennzeichnet, daß jede einzelne Justiermarke aus vier diagonal zu den Markensymmetrielinien (5M, 6M; 5W, 6W) angeordneten Auswertebereichen (1M bis 4M; 1W bis 4W) besteht, die jeweils in einer Diagonale gleich sind.

7. Verfahren nach Anspruch 6, dadurch gekennzeichnet, daß die Auswertebereiche längs der Markensymmetrielinien (5M, 6M; 5W, 6W) voneinander deutlich getrennt sind.

8. Verfahren nach Anspruch 6 oder 7, dadurch gekennzeichnet, daß die vier Auswertebereiche vorzugsweise quadratisch sind.

9. Verfahren nach Anspruch 8, dadurch gekennzeichnet, daß auf der Maskenjustiermarke die totale Linienlänge 800 µm pro 100 x 100 µm² Auswertefläche und die Linienbreite 2 µm und auf der Waferjustiermarke die totale Linienlänge 2400 µm pro 100 x 100 µm² Auswertefläche und die Linienbreite 2 µm beträgt.

10. Verfahren nach einem der Ansprüche 1 bis 9, dadurch gekennzeichnet, daß das zeilenweise Abtasten auf einer der Justiermarken im wesentlichen orthogonal zu den geraden Linien erfolgt.

## Claims

1. A method of aligning two objects relative to each other, with at least the upper object being optically transparent, particularly a wafer and a mask in semiconductor technology, with the alignment marks being superimposed while aligning and comprising parallel non-intersecting straight lines of different brightness, characterized in that
the straight lines of two directly superimposed alignment mark areas are arranged non-parallel to one another in the desired position, and
the alignment marks are optoelectronically scanned line-by-line on both objects and the resulting brightness values are integrated in a direction perpendicular thereto, wherein signals of the line pattern are generated.

2. The method according to claim 1, characterized in that the straight lines of two superimposed alignment marks are arranged essentially orthogonally to one another.

3. The method according to claim 1 or 2, characterized in that the straight lines form a periodic lattice.

4. The method according to claim 1 or 2, characterized in that the straight lines form a lattice with two or three lattice constants.

5. The method according to any of claims 1 to 4, characterized in that the line density on the wafer is higher than that on the mask.

6. The method according to any of claims 1 to 5, characterized in that every individual alignment mark consists of four evaluation areas (1M to 4M; 1W to 4W) being each identical in one diagonal and being arranged diagonally to the mark symmetry lines (5M, 6M; 5W, 6W).

7. The method according to claim 6, characterized in that the evaluation areas are distinctly separated alongside the mark symmetry lines (5M, 6M; 5W, 6W).

8. The method according to claim 6 or 7, characterized in that the four evaluation areas are preferably quadratic.

9. The method according to claim 8, characterized in that the total line length on the mask alignment mark is 800 µm per 100 x 100 µm² evaluation area and the line width is 2 µm and that the total line length on the wafer alignment mark is 2400 µm per 100 x 100 µm² evaluation area and the line width is 2 µm.

10. The method according to any one of claims 1 to 9, characterized in that the line-by-line scanning on one of the alignment marks is performed essentially orthogonally to the straight lines.

## Revendications

1. Procédé pour aligner deux objets destinés à l'alignement l'un sur l'autre, dont au moins l'objet supérieur est transparent optiquement, notamment d'une pastille et d'un masque utilisés dans la technologie des semi-conducteurs, les repères d'ajustage, qui sont constitués par des lignes droites parallèles ne se croisant pas et présentant une luminosité différente, étant superposés l'un sur l'autre lors de l'ajustage,
**caractérisé en ce que**
les lignes droites de deux zones de repères d'ajustage directement superposées sont agencées non-parallèlement entre elles dans la position prescrite, et
les repères d'ajustage sont palpés optoélectroniquement ligne par ligne sur les deux objets et les valeurs de luminosité ainsi obtenues sont intégrées dans un sens orthogonal par rapport à cela, en obtenant des signaux des réseaux de lignes.

2. Procédé selon la revendication 1, **caractérisé en ce que** les lignes droites de deux repères superposés sont agencées sensiblement de façon orthogonale entre elles.

3. Procédé selon la revendication 1 ou la revendication 2, **caractérisé en ce que** les lignes droites forment une grille périodique.

4. Procédé selon la revendication 1 ou la revendication 2, **caractérisé en ce que** les lignes droites forment une grille avec deux ou trois constantes de réseau.

5. Procédé selon l'une des revendications 1 à 4, **caractérisé en ce que** la densité des lignes sur la pastille est supérieure à celle sur le masque.

6. Procédé selon l'une des revendications 1 à 5, **caractérisé en ce que** chaque repère d'ajustage individuel consiste en quatre zones d'évaluation (1M jusqu'à 4M; 1W jusqu'à 4W) agencées diagonalement par rapport aux lignes symétriques des repères (5M, 6M; 5W, 6W), zones qui sont respectivement égales dans une diagonale.

7. Procédé selon la revendication 6, **caractérisé en ce que** les zones d'évaluation sont nettement séparées entre elles le long des lignes symétriques des repères (5M, 6M; 5W, 6W).

8. Procédé selon la revendication 6 ou 7, **caractérisé en ce que** les quatre zones d'évaluation sont de préférence quadratiques.

9. Procédé selon la revendication 8, **caractérisé en ce que** sur le repère d'ajustage la longueur de lignes totale est de 800 µm pour 100 x 100 µm² de surface d'évaluation et la largeur de lignes est de 2 µm et sur le repère d'ajustage de pastille la longueur de lignes totale est de 2400 µ pour 100 x 100 µm² de surface d'évaluation et la largeur de lignes est de 2 µm.

10. Procédé selon l'une des revendications 1 à 9, caractérisé en ce que la palpation par lignes sur l'un des repères d'ajustage se produit sensiblement dans le sens orthogonal par rapport aux lignes droites.
